(19) Europäisches Patentamt
European Patent Office
Office européen des brevets

(11) **EP 4 170 841 A1**

(12) **EUROPEAN PATENT APPLICATION**

(43) Date of publication:
**26.04.2023 Bulletin 2023/17**

(21) Application number: **22203265.8**

(22) Date of filing: **24.10.2022**

(51) International Patent Classification (IPC):
**H02H 3/38** (2006.01)

(52) Cooperative Patent Classification (CPC):
**H02H 3/38; H02H 3/46**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.10.2021 CN 202111242269**

(71) Applicant: **Silergy Semiconductor Technology (Hangzhou) Ltd**
**Hangzhou City, Zhejiang 310051 (CN)**

(72) Inventor: **HACKETT, Nathan**
**Hangzhou City Zhejiang, 310051 (CN)**

(74) Representative: **Viering, Jentschura & Partner mbB**
**Patent- und Rechtsanwälte**
**Am Brauhaus 8**
**01099 Dresden (DE)**

(54) **FAULT DETECTION METHOD AND FAULT DETECTION DEVICE**

(57) A fault detection method and device are provided. By performing a sampling operation to obtain a first voltage signal and a first current signal from a circuit path, and phases of the first voltage signal and the first current signal are adjusted to obtain a second voltage signal and a second current signal. The second voltage signal and the second current signal are transmitted to a pre-trained fault detection network for processing, such that a fault detection result is obtained. When the fault detection result indicates presence of a fault, the circuit path is controlled to be disconnected. Therefore, a fault may be detected based on the phase information and the amplitude information of the current signal and the voltage signal from the circuit path, which improves the accuracy of the fault detection.

FIG. 1

**Description**

**BACKGROUND**

**Technical Field**

The application relates to the field of electronic power technology, and more particularly, to a fault detection method and a fault detection device .

**Related Art**

The popularity of electrical equipment in daily life is getting higher and higher, which improves the convenience of daily life and work. Meanwhile, due to various reasons such as lack of standardized regulation in electricity usage, many safety hazards have also emerged. At present, most fault protection devices for a power distribution system rely on fuses which are focused on the problems of over-currents, over-loadings, and leakages in power lines. In actual working conditions, miss detection and false detection exist due to influence of environment and load types.

**SUMMARY**

In view of the aforementioned description, embodiments of the present application provide a fault detection method and a fault detection device to detect whether there is a fault in a circuit path based on phase information and amplitude information of a current signal and a voltage signal in the circuit path . accuracy of fault detection is improved so as to avoid occurrence of miss detection and false detection.
In a first aspect of the present application, an embodiment of the fault detection method is provided. The method for fault detection comprises:

> performing a sampling operation to obtain a first voltage signal and a first current signal from a circuit path;
> performing a phase adjustment on the first voltage signal and the first current signal to generate a second voltage signal and a second current signal;
> transmitting the second voltage signal and the second current signal to a pre-trained fault detection network to process and generate a fault detection result; and
> disconnecting the circuit path when a fault is detected based on the fault detection result.

In an alternative embodiment, the step of performing the phase adjustment on the first voltage signal and the first current signal comprises:

> determining a fundamental frequency of the first voltage signal;
> obtaining phase information of the first voltage signal at the fundamental frequency; and
> adjusting phases of the first voltage signal and the first current signal according to the phase information.

In an alternative embodiment, the step of obtaining the phase information of the first voltage signal at the fundamental frequency comprises:
performing a discrete Fourier transform on the first voltage signal to obtain the phase information of the first voltage signal.
In an alternative embodiment, the step of transmitting the second voltage signal and the second current signal to the pre-trained fault detection network to process and generate the fault detection result comprises:
after the phase adjustment, transmitting the second voltage signal and the second current signal to the pre-trained fault detection network, wherein spectrum information of the second voltage signal and the second current signal are processed to obtain the fault detection result, and the spectrum information comprises phase information and amplitude information.
In an alternative embodiment, the spectrum information further comprises frequency information.
In an alternative embodiment, the step of performing the phase adjustment on the first voltage signal and the first current signal further comprises:
when a phase difference exists between a sampling clock of the first voltage signal and a sampling clock of the first current signal, performing the phase adjustment on the first current signal according to the phase difference.
In an alternative embodiment, the step of performing the phase adjustment on the first voltage signal and the first current signal further comprises:
when there is no consistent phase correlation between sample rates for the first voltage signal and the first current signal and an operation frequency in the circuit path, performing the phase adjustment on the first voltage signal and the first current signal according to a random phase.

In an alternative embodiment, the step of transmitting the second voltage signal and the second current signal to the pre-trained fault detection network to process and generate the fault detection result comprises:

performing a frequency normalization on the second voltage signal and the second current signal, transmitting the second voltage signal and the second current signal after the frequency normalization to the pre-trained fault detection network for processing, and obtaining the pre-trained fault detection result from the fault detection network.

In an alternative embodiment, the step of performing the frequency normalization on the second voltage signal and the second current signal comprises:

performing a spectrogram scaling on the second voltage signal and the second current signal through interpolation filtering or spline interpolation to normalize frequencies of the second voltage signal and the second current signal.

In an alternative embodiment, the pre-trained fault detection network is pre-trained with the following steps:

performing the sampling operation to respectively obtain multiple raw voltage signals and raw current signals under a normal condition and a fault condition;

performing phase adjustments on each of the raw voltage signals and the raw current signals to respectively generate samples of the raw voltage signals and samples of the raw current signals;

transmitting each of the samples of the raw voltage signals and each of the samples of the raw current signals, and corresponding condition information to the pre-trained fault detection network for processing, such that the fault detection network is trained; wherein the corresponding condition information comprises an indication of the normal condition or the fault condition.

In a second aspect of the application, an embodiment of the fault detection device is provided. The fault detection device comprises:

a sampling module (11), configured to perform a sampling operation to obtain a first voltage signal and a first current signal from a circuit path;

a phase adjustment module (12), configured to performing a phase adjustment on the first voltage signal and the first current signal to generate a second voltage signal and a second current signal; and

a processor (13), configured to transmit the second voltage signal and the second current signal to a pre-trained fault detection network to process and generate a fault detection result, and control a connection of the circuit path according to the fault detection result.

In an alternative embodiment, the phase adjustment module (12) comprises a phase locker (PLL22).

The phase locker (PLL22) is configured to determine a fundamental frequency of the first voltage signal, obtain phase information of the first voltage signal at the fundamental frequency, and adjust phases of the first voltage signal and the first current signal according to the phase information.

In an alternative embodiment, the phase locker (PLL22) comprises a first frame buffer unit (221) and a first DFT unit (222);

the first frame buffer unit (221) is connected to the sampling module (11), and is configured to buffer samples of the first voltage signal for at least one DFT cycle;

the first DFT unit (222) is connected to the first frame buffer unit (221), and is configured to perform a discrete Fourier transform on the samples of the first voltage signal output from the first frame buffer unit (221) to obtain the phase information, and to feedback the phase information to the first frame buffer unit (221); and

the first frame buffer unit (221) is further configured to adjust a phase of the first voltage signal according to the phase information.

In an alternative embodiment, the fault detection device further comprises a second frame buffer unit (223) and a second DFT unit (224);

the second frame buffer unit (223) is respectively connected to the sampling module (11) and the phase locker (PLL22), and is configured to buffer samples of the first current signal for at least one DFT cycle, and to adjust a phase of the first current signal according to the phase information to obtain a second current signal;

the second DFT unit (224) is configured to perform a discrete Fourier transform on the second current signal.

In an alternative embodiment, the second frame buffer unit (223) is further configured to calculate a phase difference between a sampling clock of the first voltage signal and a sampling clock of the first current signal, and to adjust the phase of the first current signal according to the phase difference.

In an alternative embodiment, the fault detection device further comprises a frequency normalization module

(24).

The frequency normalization module (24) is connected to a first DFT unit (222) and a second DFT unit (224), and is configured to perform a spectrogram scaling on the second voltage signal and the second current signal after a discrete Fourier transform through interpolation filtering or spline interpolation to normalize frequencies of the second voltage signal and the second current signal.

In an alternative embodiment, the sampling module (11) comprises:

a voltage signal sampling circuit (211), configured to sample from the circuit path to acquire the first voltage signal; and

a current signal sampling circuit (212), configured to sample from the circuit path to acquire the first current signal.

The embodiments of the fault detection method and the fault detection device obtain a first voltage signal and a first current signal by performing a sampling operation on a circuit path. The first voltage signal and the first current signal are under phase adjustments to obtain a second voltage signal and a second current signal. The second voltage signal and the second current signal are input to a pre-trained fault detection network for processing, such that a fault detection result is obtained. When the fault detection result indicates presence of a fault, the circuit path is controlled to be disconnected. Therefore, the embodiment allows a circuit fault to be detected based on phase information and amplitude information of the current signal and voltage signal in the circuit path, which improves the accuracy of fault detection, thereby avoiding occurrences of miss detection and false detection.

## BRIEF DESCRIPTION OF THE DRAWINGS

The above and other objectives, features and advantages of the present application will be better clarified in the following description of embodiments of the present application with reference to the accompanying drawings, wherein in the drawings:

FIG. 1 shows a circuit diagram of a fault detection device according to an embodiment of the present application;
FIG. 2 shows a circuit diagram of a fault detection device according to another embodiment of the present application;
FIG. 3 shows a circuit diagram of a fault detection device according to a further embodiment of the present application;
FIG. 4 is a flowchart of a fault detection method according to an embodiment of the present application;
FIG. 5 is a flowchart of a training method for a fault detection network according to an embodiment of the present application.

## DETAILED DESCRIPTION OF THE EMBODIMENTS

The present application is described hereafter based on the embodiments; however, the present application is not limited to the embodiments. In the following detailed description of the present application, some specific details are described in detail. For those skilled in the art without the description of these detailed portions may also fully understand the present application. To avoid confusion of the essence of the present application, well-known methods, processes, processes, components, and circuits are not described in detail.

Furthermore, it is to be acknowledged for those of ordinary skill in the art that the drawings provided herein are for illustrative purposes, and the drawings are not necessarily drawn in proportion.

Meanwhile, it is to be understood that, in the following description, "circuit" refers to a conductive circuit composed of at least one element or sub-circuit through an electrical connection or electromagnetic connection. When said element or circuit is "connected" to another component or said component /circuit is "connected between" two nodes, it may be directly or indirectly coupled or connected to another component, with or without the presence of intermediate elements. The connection between the elements may be physical, logical, or a combination thereof. Conversely, when a component is said to be "directly coupled" or "directly connected" to another component, it means that there is no intermediate component therebetween.

Unless specifically defined in the context, the synonyms such as "include" and "comprise" should be broadly interpreted in inclusive manner, rather than in exclusive or exhaustive manner. That is, the meaning of "comprise" is referred to as "include but is not limited to".

In the description of the present application, it is to be understood that the terms "first", "second" and the like are used for descriptive purposes, and cannot be construed as indicating or implying relative importance. Furthermore, in the description of the present application, unless otherwise indicated, "multiple" means two or more.

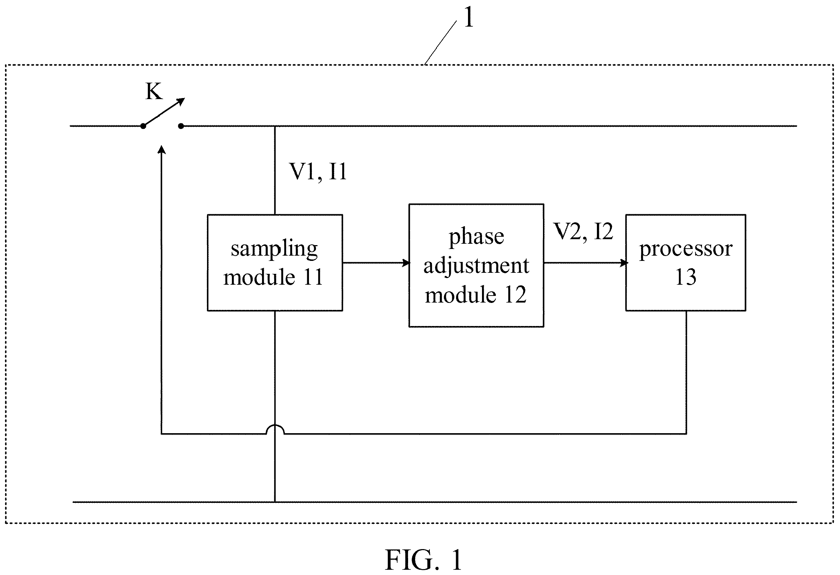

FIG. 1 shows a circuit diagram of a fault detection device according to an embodiment of the present application. As shown in FIG. 1, the fault detection device 1 of an embodiment of the present application includes a sampling module 11, a phase adjustment module 12 and a processor 13.

In the present embodiment, the sampling module 11 is configured to sample a circuit path to obtain a first voltage signal V1 and a first current signal I1. The phase adjustment module 12 is configured to perform a phase adjustment on the first voltage signal V1 and the first current signal I1 to generate a second voltage signal V2 and a second current signal 12. The processor 13 is configured to transmit the second voltage signal V2 and the second current signal 12 into a pre-trained fault detection network for processing to obtain a fault detection result, and to control the connection of the circuit path according to the fault detection result. Optionally, the second voltage signal V2 and the second current signal 12 are processed by a discrete Fourier transform before being into the fault detection network, such that the spectrum information of the second voltage signal V2 and the second current signal 12 are processed to obtain the fault detection result. The spectrum information includes phase information and amplitude information. In a further alternative embodiment, the spectrum information may also include frequency information of electrical signals (a voltage signal and a current signal).

In the present embodiment, if the fault detection result shows that there is a fault in the circuit path, the switch K is controlled to be disconnected to ensure the electricity safety. In an alternative embodiment, a fuse or other control circuit may be employed to control the switch K to ensure the electricity safety in the event of the fault.

In an alternative embodiment, the pre-trained fault detection network is a neural network. It should be understood that the embodiment does not limit the type of the neural network. For example, at least Convolutional Neural Network (CNN) or Recurrent Neural Network (RNN) is applicable to the embodiment.

In the embodiments of the present application, phase adjustments are performed on the current signal and the voltage signal sampled from the circuit path, and the fault detection network is able to detect whether there is a fault in a circuit based on the phase information and the amplitude information of the current signal and the voltage signal in the circuit path, thereby improving the accuracy of fault detection.

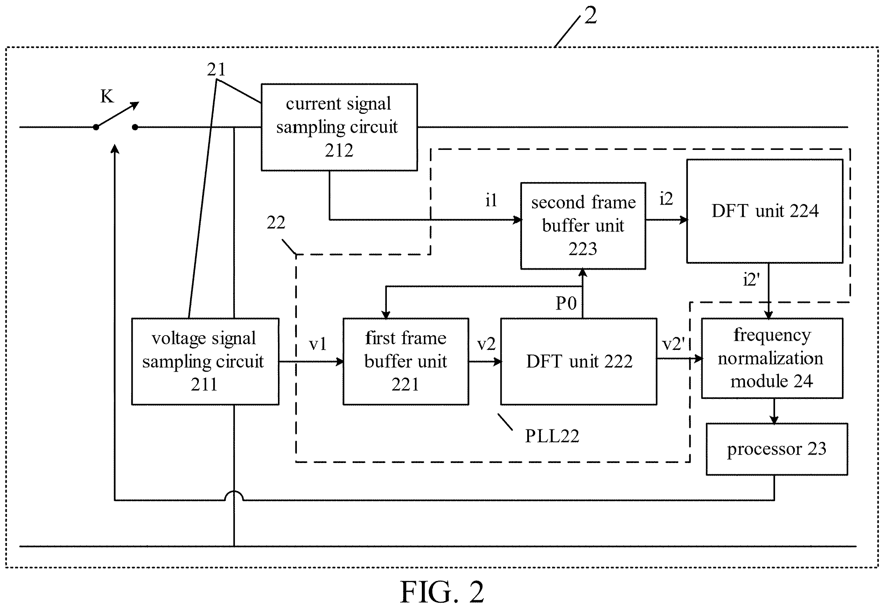

FIG. 2 shows a circuit diagram of a fault detection device according to another embodiment of the present application. As an optional implementation shown in FIG. 2, the sampling module 21 includes a voltage signal sampling circuit 211 and a current signal sampling circuit 212. The voltage signal sampling circuit 211 is configured to sample a voltage signal v1 from the circuit path, whereas the current signal sampling circuit 212 is configured to sample a current signal i1 from the circuit path.

In an alternative implementation, the phase adjustment module 22 includes a phase locker PLL22. The phase locker PLL22 is configured to determine a fundamental frequency $f_0$ of the voltage signal v1, and obtain the phase information P0 of the voltage signal v1 at the fundamental frequency $f_0$. The voltage signal v1 and the current signal i1 are under phase adjustments based on the phase information P0 of the voltage signal v1 at the fundamental frequency $f_0$, such that the phase of the voltage signal v2 is maintained at zero. In the process of electrical signal transmission, electrical signals are inevitably accompanied with harmonic components. Therefore, in the present embodiment, the fundamental frequency $f_0$ of the voltage signal v1 is first determined. For example, the fundamental frequency of the power grid is generally 50Hz. In the present embodiment, a spectrum analyzer may be used to measure the fundamental frequency of the voltage signal v1, or alternatively, a frequency counter may be used to measure the frequency of the lowest frequency wave in the voltage signal v1 to determine the fundamental frequency. It should be understood that the embodiment does not limit the methods for determining the fundamental frequency.

In an alternative embodiment, the first frame buffer unit 221 and the first discrete Fourier transform (DFT) unit 222 form a phase locker PLL22. The first frame buffer unit 221 is connected to the voltage signal sampling circuit 211, receives and buffers samples of the voltage signal v1 for at least one DFT cycle, and the buffered samples of the voltage signal v1 are subsequently processed in the DFT unit 222. The DFT unit 222 is connected to the first frame buffer unit 221, and is configured to perform the discrete Fourier transform on the buffered samples of the voltage signal v1 output from the first frame buffer unit 221 to obtain the current phase information. The current phase information is feedback to the first frame buffer unit 221, such that the first frame buffer unit 221 performs the phase adjustment on the voltage signal v1 according to the current phase information. The operation is repeated until the phase information P0 at the fundamental frequency $f_0$ is determined.

In an alternative implementation, the phase adjustment module 22 performs the phase adjustment on the voltage signal and the current signal sampled from the circuit path with the following steps.

A voltage signal v1 being sampled from the circuit path is expressed as:

$$v1(t) = A\,cos(\omega_0 t + \Phi) \qquad (1)$$

where A is the amplitude of the voltage signal v1, $\omega_0 = 2\pi f_0$, where $f_0$ is the fundamental frequency of the voltage signal v1, and $\Phi$ is the phase of the voltage signal v1 at the fundamental frequency $f_0$. That is, P0 is assumed to be $\Phi$.

Optionally, the above expression (1) with the voltage signal v1 is converted into an exponential expression by using Euler's identity:

$$v1(t) = \left(\frac{A}{2}e^{i\Phi}\right)e^{i\omega_0 t} + \left(\frac{A}{2}e^{-i\Phi}\right)e^{-i\omega_0 t} \quad (2)$$

In the present embodiment, the first frame buffer unit 221 may buffer a sufficient number of samples of the voltage signal v1 (the amount of voltage signal samples collected for at least one DFT cycle) to perform the discrete Fourier transform on the buffered samples of the voltage signal v1 by using a predetermined DFT window.

The DFT unit 222 performs a discrete Fourier transform on the buffered samples of the voltage signal v1 to obtain the transformed voltage signal $X(\omega)$:

$$X(\omega) = \sum_{t=0}^{N-1} v(t)e^{-i\omega t} \quad (3)$$

where N is the size of the DFT window, that is, the number of sample points.

The exponential expression (2) with the voltage signal v1 is substituted into Equation (3) as follows:

$$X(\omega_0) = \sum_{t=0}^{N-1}\left(\left(\frac{A}{2}e^{i\Phi}\right)e^{i\omega_0 t} + \left(\frac{A}{2}e^{-i\Phi}\right)e^{-i\omega_0 t}\right)e^{-i\omega_0 t}$$

$$= \sum_{t=0}^{N-1}\left(\left(\frac{A}{2}e^{i\Phi}\right) + \left(\frac{A}{2}e^{-i\Phi}\right)e^{-i2\omega_0 t}\right)$$

$$= \sum_{t=0}^{N-1}\left(\frac{A}{2}e^{i\Phi}\right) + \sum_{t=0}^{N-1}\left(\left(\frac{A}{2}e^{-i\Phi}\right)e^{-i2\omega_0 t}\right)$$

$$= \sum_{t=0}^{N-1}\left(\frac{A}{2}e^{i\Phi}\right) \quad (4)$$

where the fundamental frequency $f_0$ is not zero, so $\omega_0$ is not 0, and the number of sample points N is large enough, hence:

$$\sum_{t=0}^{N-1}\left(\left(\frac{A}{2}e^{-i\Phi}\right)e^{-i2\omega_0 t}\right) = 0$$

The result of the discrete Fourier transform is further converted by using Euler's identity to yield the follows:

$$X(\omega_0) = \frac{NA}{2}cos(\Phi) + i\frac{NA}{2}sin(\Phi) \quad (5)$$

Let $a_{\omega_0}$ be the real part of the expression (5) and $b_{\omega_0}$ the imaginary part of the expression (5), then:

$$\frac{b_{\omega_0}}{a_{\omega_0}} = \frac{\frac{NA}{2}sin(\Phi)}{\frac{NA}{2}cos(\Phi)} = tan(\Phi)$$

$$\Phi = tan^{-1}\left(\frac{b_{\omega_0}}{a_{\omega_0}}\right)$$

Thus, the embodiment enables determination of the phase $\Phi$ of the voltage signal v1 at the fundamental frequency after performing the discrete Fourier transform on the voltage signal v1 sampled from the circuit path.

In the present embodiment, the first frame buffer unit 221 shifts the buffered samples of the voltage signal v1 based on the phase information P0 determined by the DFT unit 222, such that the phase of the voltage signal v1 is adjusted. Assuming that the first frame buffer unit 221 is under the phase shift for (-$\Phi$), the expression of the samples of phase-adjusted voltage signal (i.e., the second voltage signal v2) becomes:

$$v2(t) = A\cos(\omega_0 t + \Phi - \Phi) = A\cos(\omega_0 t)$$

The DFT unit 222 performs the discrete Fourier transformation on the voltage signal v2 to obtain a discrete voltage signal v2'.

The phase information at the fundamental frequency is determined and the phase adjustments on the samples of the electrical signal are performed according to the phase information at the fundamental frequency, in order to use the phase information at the fundamental frequency as a reference of all harmonic waves and noise phases, such that the fault detection network configured in the processor 23 is less sensitive to phase fluctuations caused by the input frequency of the electrical signals. Hence, the fault detection network may be applicable to the phase information and the amplitude information of the samples of the electrical signal , which significantly increases the amount of information adaptable for the fault detection network, and further improves the efficiency of the fault detection.

In an alternative embodiment, the fault detection device 2 further comprises a second frame buffer unit 223 and a DFT unit 224. The second frame buffer unit 223 is connected to the DFT unit 222 and the current sampling module 212 and is configured to buffer samples of the current signal i1 for at least one DFT cycle, and to perform the phase adjustment on the current signal i1 according to the aforementioned phase information P0 to obtain the current signal i2. The DFT unit 224 is configured to perform the discrete Fourier transform on the current signal i2 to respectively obtain a discrete current signal i2'.

The electrical signals in a frame buffer are shifted to adjust phases of electrical signal samples. It should be understood that the other signal processing methods, such as through the Hilbert filter, are also applicable for phase adjustments. The embodiment does not limit the actual implementations of phase adjustments.

As an alternative implementation, in a specific application scenario, the sampling clocks for voltage sampling and current sampling may have phase differences, which may affect the fault detection result. Hence, in the present embodiment, the second frame buffer unit 223 is configured to further perform phase adjustments on the current signal i1 according to a phase difference when the phase difference is occurred between the sampling clocks in the voltage sampling circuit 211 and the current sampling circuit 212. The influences of clock differences in sampling for the electrical signal are eliminated to further improve the accuracy of the fault detection.

In an alternative implementation, if there is no consistent phase correlation between the sampling clock of the electrical signal and the frequency of the electrical signal, random phase information may be generated based on application scenarios, and the phase adjustment are performed on the voltage signal and current signal based on the random phase information. The voltage signal and the current signal after the phase adjustments are then used in the fault detection. Hence, more viable information may be submitted to the fault detection network to improve the accuracy of the fault detection.

In an alternative implementation, in the case that the fundamental frequency of the electrical signal is variable or undeterminable, fluctuations of the fundamental frequency may affect the fault detection result. Hence, the present embodiment proposes a normalization on the frequency of the electrical signal to avoid the consequences induced by the undeterminable fundamental frequency fluctuation. The accuracy of fault detection is further improved. Specifically, the fault detection device 2 further comprises a frequency normalization module 24. The frequency normalization module 24 is connected to the DFT unit 222 and the DFT unit 224, and is configured to perform a spectrogram scaling by using interpolation filtering or spline interpolation on the voltage signal v2' and the current signal i2' after the discrete Fourier transform, so as to normalize the frequencies of the voltage signal v2' and the current signal i2'.

The processor 23 receives the scaled spectrogram of the voltage signal and the current signal, such that the fault detection network processes the phase information, the amplitude information and the frequency information in the spectrograms of the voltage signal and the current signal to obtain a fault detection result. When the fault is detected, the switch K in the circuit path is controlled to be disconnected to ensure the electrical safety. In an alternative embodiment, the fault detection network is a neural network. It should be understood that the embodiment does not limit the type of the neural network. For example, at least CNN or RNN is applicable to the embodiment. It should be understood that the training mechanism is applicable to any existed fault detection method, so that the neural network determines the fault according to the variation of the phase, the amplitude, the frequency and the like when the fault emerges and the details of the operation of the neural network would not be described herein.

In an alternative embodiment, the fault detection device 2 includes a processor 23. The processor 23 may be a digital signal processor (DSP), an application-specific integrated circuit (ASIC), a programmable logic device (PLD), and the like. In the embodiment, the fault detection device 2 executes corresponding logic instructions in the first frame buffer unit 221, the DFT unit 222, the second frame buffer unit 223, the DFT unit 224, the frequency normalization module 24 and other processing units to process the voltage signal and the current signal in the circuit path. In one embodiment, the aforementioned processing units may be separate program modules executable by the processor 23 to execute corresponding functions. In the another embodiment, the aforementioned processing units may be fixed circuit structures with predetermined connection schemes to execute respective functions.

The first voltage signal and the first current signal are obtained by performing a sampling operation on a circuit path. The phases of the first voltage signal and the first current signal are adjusted to generate the second voltage signal and the second current signal, respectively. The second voltage signal and the second current signal are transmitted to the pre-trained fault detection network for processing and the fault detection result is generated. When the fault detection result indicates the presence of the fault, the circuit path is controlled to be disconnected. Therefore, in the present embodiment, the circuit fault may be detected based on the phase information and the amplitude information of the current signal and the voltage signal in the circuit path, thereby improving the accuracy of the detection.

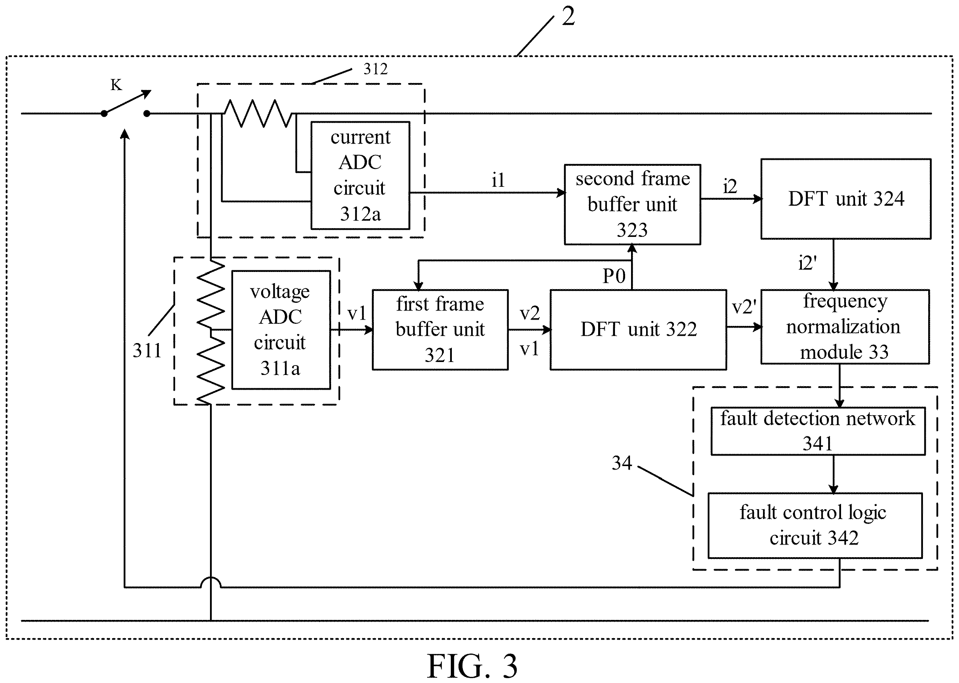

FIG. 3 shows a circuit diagram of a fault detection device according to a further embodiment of the present application. As shown in FIG. 3, in the present embodiment, the voltage sampling circuit 311 includes a voltage divider circuit and a voltage ADC circuit 311a. The voltage divider circuit is connected to the circuit path to obtain the voltage of the circuit path. The voltage ADC circuit 311a is configured to sample a voltage signal v1 from the voltage divider circuit, and the sampling rate fsv of the voltage ADC circuit 311a is configured according to practical scenarios in specific applications. The current sampling circuit 312 includes a shunt resistor and a current ADC circuit 312a. The shunt resistor is connected in series with the circuit path to obtain the current of the circuit path, and it should be understood that the voltage across the shunt resistor may represent the current flowing through the circuit path. The current ADC circuit 312a is used to sample a current signal i1 from the shunt resistor, and the sampling rate fsa of the current ADC circuit 312a is configured according to practical scenarios in specific applications. As an optional implementation preference, the sampling clocks for the voltage sampling circuit 311 and the current sampling circuit 312 may be identical.

The voltage ADC circuit 311a transmits the sampled voltage signal v1 to the first frame buffer unit 321. The first frame buffer unit 321 buffers the samples of the voltage signal v1 for at least one DFT cycle, and transmits the buffered samples of the voltage signal v1 to the DFT unit 322.

The DFT unit 322 is configured to perform the discrete Fourier transform on the buffered samples of the voltage signal v1 to obtain a current phase information thereof. Thereafter, the current phase information is feedback to the first frame buffer unit 321, such that the first frame buffer unit 321 adjust the phase of the voltage signal v1 according to the current phase information. The feedback operation is repeated until the phase information P0 at the fundamental frequency $f_0$ is determined. It should be understood that the phase determination process of the buffered samples of the voltage signal sample is similar to the aforementioned embodiment, and thus is not repeated herein.

The DFT unit 322 is further configured to receive the voltage signal v2 after the phase adjustments of the first frame buffer unit 321, and to perform the discrete Fourier transform on the voltage signal v2 to generate the voltage signal v2', thereby obtaining the spectrogram of the voltage signal in the circuit path.

The current ADC circuit 312a transmits the sampled current signal i1 to a second frame buffer unit 323. The second frame buffer unit 323 receives the current signal i1 and a phase information P0 from the DFT unit 322, and adjusts the phase of the current signal i1 according to the phase information P0, and transmits a plurality of phase adjusted current signal i1 collected during at least one DFT cycle to the DFT unit 324

In an alternative implementation, if there are phase differences between the sample clocks of the voltage sampling and current sampling, the second frame buffer unit 323 is configured to further adjust the phase of the current signal i1 according to the phase differences between the sample clocks of the voltage sampling circuit 311 and the current sampling circuit 312, so as to eliminate the influences caused by the difference of sampling clocks for sampling the electrical signal, and to further improve the accuracy of the fault detection.

The DFT unit 324 is configured to receive the phase adjusted current signal i2 from the second frame buffer unit 323 and convert the current signal i2 to the current signal i2' via DFT conversion to obtain a spectrogram of current signal in the circuit path.

In an embodiment, the phase adjustment is performed on electrical signals by shifting the electrical signals in a frame buffer. It should be understood that other signal processing methods, such as through the Hilbert filter, are also applicable for phase adjustments. The embodiment does not limit the actual implementations of phase adjustments.

The phase information at the fundamental frequency is determined to perform phase adjustments on the electrical signal samples based on the phase information. The phase information at the fundamental frequency is used as a reference for all harmonic waves and noise phases, such that the fault detection network configured in the processor 23 is less sensitive to phase fluctuations caused by the input frequency of the electrical signal. Hence, the fault detection network may be applicable to the phase information and the amplitude information in the samples of the electrical signal, which significantly increases the amount of information adaptable for the fault detection network, and further improves the efficiency of the fault detection.

In an alternative implementation, if there is no consistent phase correlation between the sampling clock of the electrical signal and the frequency of the electrical signal, random phase information may be generated based on application scenarios, and the phase adjustment is performed on the voltage signal and the current signal according to the random phase information. The voltage signal and current signal after phase adjustments are then used in the fault detection. Hence, more viable information may be submitted to the fault detection network to improve the accuracy of the fault detection.

In an alternative implementation, in the case that the fundamental frequency of the electrical signal is variable or undeterminable, fluctuations of the fundamental frequency may affect the fault detection result. Hence, the embodiment proposes a normalization on the frequency of the electrical signal to avoid the consequences induced by the undeterminable fundamental frequency fluctuation. The accuracy of fault detection is further improved. Specifically, the frequency normalization module 33 is configured to receive a spectrogram of the voltage signal v2' from the DFT unit 322 and a spectrogram of the current signal i2' from the DFT unit 324, and performs the spectrogram scaling by using the interpolation filtering or the spline interpolation on the spectrograms of the voltage signal v2' and the current signal i2'to normalize the frequencies of the voltage signal v2' and the current signal i2'.

The fault detection network 341 in the processor 34 receives the scaled voltage signal spectrogram and the current signal spectrogram, such that the fault detection network processes the phase information, the amplitude information and the frequency information in the voltage signal spectrogram and the current signal spectrogram to obtain the fault detection result. The fault control logic circuit 342 in the processor 34 receives the fault detection result, and controls the switch K in the circuit path to be disconnected to ensure the electrical safety when a fault is detected. In an alternative embodiment, the fault detection network is a neural network. It should be understood that the embodiment does not limit the type of the neural network. For example, at least CNN or RNN is applicable to the embodiment.

In the embodiment of the present application, the first voltage signal and the first current signal are sampled by performing the sampling operation on the circuit path. The phases of the samples of the first voltage signal and the first current signal are adjusted to obtain the second voltage signal and the second current signal. The second voltage signal and the second current signal are transmitted to the pre-trained fault detection network for processing in order to obtain the fault detection result. When the fault detection result indicates the presence of the fault, the circuit path is controlled to be disconnected. Therefore, in the present embodiment, the circuit fault may be detected based on the phase information and the amplitude information of the current signal and the voltage signal in the circuit path and the accuracy of the detection may be improved.

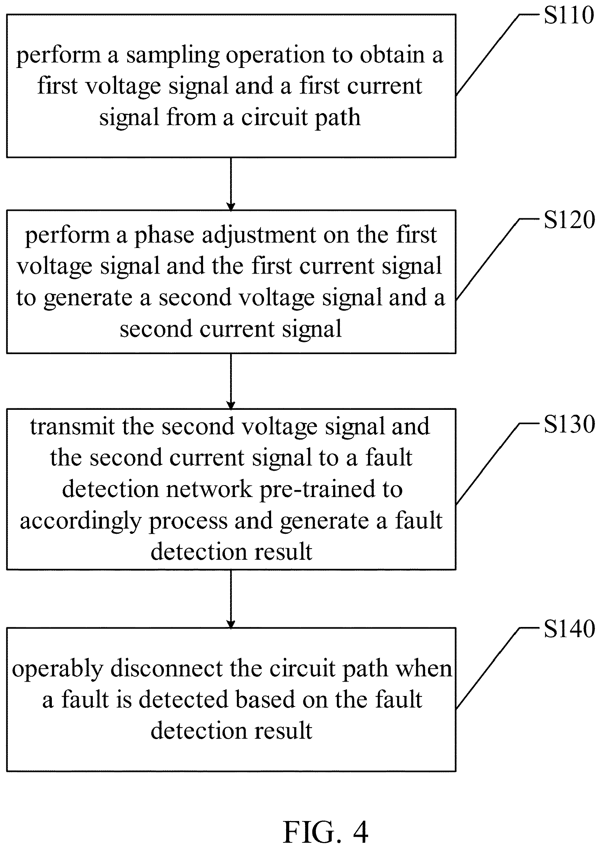

FIG. 4 is a flowchart of a fault detection method according to an embodiment of the present application. As shown in FIG. 4, the fault detection method comprises the following steps:

In step S110, a sampling operation is performed to obtain a first voltage signal and a first current signal from a circuit path. In the present embodiment, the voltage signal and the current signal in the circuit path are respectively obtained by a voltage sampling circuit and a current sampling circuit.

In step S120, phase adjustments are respectively performed on the first voltage signal and the first current signal to generate a second voltage signal and a second current signal.

In an alternative implementation, step S120 comprises the following steps. A fundamental frequency of the first voltage signal is determined. Phase information of the first voltage signal at the fundamental frequency is obtained. Phases of the first voltage signal and the first current signal are adjusted according to the phase information to obtain the second voltage signal and the second current signal .

The phase information at the fundamental frequency is determined to perform phase adjustments on the samples of the electrical signal based on the phase information at the fundamental frequency. The phase information at the fundamental frequency is used as a reference for all harmonic waves and noise phases, such that the fault detection network is less sensitive to phase fluctuations caused by the input frequency of the electrical signal. Hence, the fault detection network may be applicable to the phase information and the amplitude information in the samples of the electrical signal, which significantly increases the amount of information adaptable for the fault detection network, and further improves the efficiency of the fault detection.

In an alternative implementation, the step of obtaining the phase information of the first voltage signal at the fundamental frequency may comprise: performing a discrete Fourier transform on the first voltage signal to obtain the phase information of the first voltage signal at the fundamental frequency. Determination of the phase information at the fundamental frequency, is analogous to that in the aforementioned embodiments, and therefore is not repeated herein.

In an alternative implementation, step S120 further comprises the following steps. When a phase difference exists between a sampling clock of the first voltage signal and a sampling clock of the first current signal, a phase adjustment is performed on the first current signal according to the phase difference. As a result, the influences of sampling clock differences in electrical signal may be mitigated, and the accuracy of fault detection is further improved.

In an alternative implementation, step S120 further comprises the following steps. When sample rates for the first voltage signal and the first current signal do not have consistent phase correlations with an operation frequency of the circuit path, the phase adjustments are performed on the first voltage signal and the first current signal by using a random phase. As a result, more viable information of the fault detection network may be increased and the accuracy of the fault detection is increased.

In step S130, the second voltage signal and the second current signal are transmitted to the pre-trained fault detection network for process in order to obtain the fault detection result.

In step S140, when the fault detection result indicates a presence of a fault, the circuit path is controlled to be disconnected.

In an alternative embodiment, step S130 comprises the following steps. The second voltage signal and the second current signal are converted by the discrete Fourier transform and then transmitted to the fault detection network, and the fault detection network processes the spectrum information of the second voltage signal and the second current signal to obtain the fault detection result. The spectrum information includes the phase information and the amplitude information. In the present embodiment, since the voltage signal and the current signal are under phase adjustments according to the fundamental frequency, the phase of the fundamental frequency may be used as a reference for all harmonic waves and noise phases. Hence, the fault detection network may be applicable to the phase information and the amplitude information of the samples of the electrical signal, which significantly increases the amount of information adaptable for the fault detection network, and further improves the efficiency of the fault detection.

In another alternative implementation, the spectrum information further comprises the frequency information of the voltage signal and the current signal.

Optionally, step S130 further comprises the following steps. A frequency normalization is performed on the second voltage signal and the second current signal. The second voltage signal and the second current signal after the frequency normalization are transmitted to the fault detection network for processing in order to obtain the fault detection result. Optionally, a spectrogram scaling is performed on the second voltage signal and the second current signal through interpolation filtering or spline interpolation to normalize frequencies of the second voltage signal and the second current signal. The steps are advantageous for avoiding the influences caused by undeterminable fundamental frequency variations, which further improve the accuracy of the fault detection.

In the present embodiment, the fault detection network is a neural network. It should be understood that the embodiment does not limit the type of the neural network. For example, at least CNN or RNN is applicable to the embodiment.

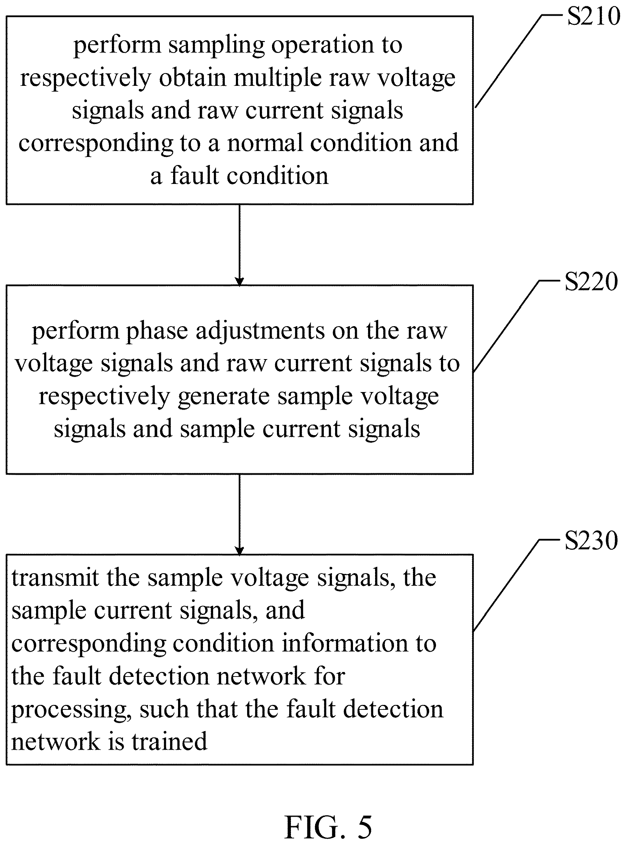

FIG. 5 is a flowchart of a training method for a fault detection network according to an embodiment of the present application. In an alternative implementation, as shown in FIG. 5, the fault detection network of the embodiment is trained by the following steps.

In step S210, a sampling operation is performed to obtain multiple raw voltage signals and raw current signals under normal and fault conditions.

In step S220, phase adjustments are performed on each of the raw voltage signals and each of the raw current signals to respectively generate samples of the raw voltage signal and samples of the raw current signals.

In step S230, each of the samples of the raw voltage signals and the raw sample current signals, and corresponding condition information are transmitted to the fault detection network for processing, such that the fault detection network is trained. The corresponding condition information comprises an indication of a normal condition or a fault condition.

As an optional embodiment, the samples of the raw current signals, the samples of the raw voltage signals, and corresponding condition information are transmitted to the fault detection network for processing, such that the fault detection network processes the amplitude information, the phase information, the frequency information, and in the spectrum information of the electrical signal to generate the fault detection result. Based on a condition corresponding to the fault detection result, the current samples of the current signals, and the current samples of the voltage signals, parameters in the fault detection network are adjusted. When the fault detection network is able to generate a fault detection result that matches the corresponding condition, the training of the fault detection network is concluded.

In the embodiments, a first voltage signal and a first current signal are obtained by performing a sampling operation on a circuit path. The phases of the first voltage signal and the first current signal are adjusted to obtain a second voltage signal and a second current signal. The second voltage signal and the second current signal are transmitted to a pre-trained fault detection network for processing, such that a fault detection result is obtained. When the fault detection result indicates presence of a fault, the circuit path is controller to be disconnected. Therefore, a circuit fault may be detected based on the phase information and the amplitude information of the current signal and the voltage signal in the circuit path. More viable information is provided to the fault detection network, so that the accuracy of the detection is improved.

The above descriptions present preferred embodiments of the present application, but is not intended to limit the present application. For those skilled in the art, the present application may be realized in various modifications and variations. Any modifications, equivalent substitutions, improvements, etc. made within the spirit and principles of the present application shall be included within the scope of the present application.

**Claims**

1. A fault detection method, **characterized in that**, the fault detection method comprises:

   performing a sampling operation to obtain a first voltage signal and a first current signal from a circuit path;
   performing a phase adjustment on the first voltage signal and the first current signal to generate a second voltage signal and a second current signal;
   transmitting the second voltage signal and the second current signal to a pre-trained fault detection network to process and generate a fault detection result; and
   disconnecting the circuit path when a fault is detected based on the fault detection result.

2. The fault detection method according to claim 1, **characterized in that**, performing the phase adjustment on the first voltage signal and the first current signal comprises:

   determining a fundamental frequency of the first voltage signal;
   obtaining phase information of the first voltage signal at the fundamental frequency; and
   adjusting phases of the first voltage signal and the first current signal according to the phase information.

3. The fault detection method according to claim 2, **characterized in that**, obtaining the phase information of the first voltage signal at the fundamental frequency comprises:
   performing a discrete Fourier transform on the first voltage signal to obtain the phase information of the first voltage signal.

4. The fault detection method according to any one of claims 1 to 3, **characterized in that**, the step of transmitting the second voltage signal and the second current signal to the pre-trained fault detection network to process and generate the fault detection result comprises:
   after the phase adjustment, transmitting the second voltage signal and the second current signal to the pre-trained fault detection network, wherein spectrum information of the second voltage signal and the second current signal are processed to obtain the fault detection result, and the spectrum information comprises phase information and amplitude information.

5. The fault detection method according to claim 4, **characterized in that**, the spectrum information further comprises frequency information.

6. The fault detection method according to claim 1 or 2, **characterized in that**, performing the phase adjustment on the first voltage signal and the first current signal further comprises:
   when a phase difference exists between a sampling clock of the first voltage signal and a sampling clock of the first current signal, performing the phase adjustment on the first current signal according to the phase difference.

7. The fault detection method according to any one of claims 1 to 6, **characterized in that**, performing the phase adjustment on the first voltage signal and the first current signal further comprises:
   when there is no consistent phase correlation between sample rates for the first voltage signal and the first current signal and an operation frequency in the circuit path, performing the phase adjustment on the first voltage signal and the first current signal according to a random phase.

8. The fault detection method according to any one of claims 2 to 7, **characterized in that**, transmitting the second voltage signal and the second current signal to the pre-trained fault detection network pre-trained to process and generate the fault detection result comprises:

   performing a frequency normalization on the second voltage signal and the second current signal;
   transmitting the second voltage signal and the second current signal after the frequency normalization to the pre-trained fault detection network for processing; and
obtaining the fault detection result from the pre-trained fault detection network.

9. The fault detection method according to claim 8, **characterized in that**, performing the frequency normalization on the second voltage signal and the second current signal comprises:
performing a spectrogram scaling on the second voltage signal and the second current signal through interpolation filtering or spline interpolation to normalize frequencies of the second voltage signal and the second current signal.

10. The fault detection method according to any one of claims 1 to 9, **characterized in that**, the pre-trained fault detection network is pre-trained with the following steps:

performing the sampling operation to respectively obtain multiple raw voltage signals and raw current signals under a normal condition and a fault condition;
performing phase adjustments on each of the raw voltage signals and the raw current signals to respectively generate samples of the raw voltage signals and samples of the raw current signals;
transmitting each of the samples of the raw voltage signals and each of the samples of the raw current signals, and corresponding condition information to the pre-trained fault detection network for processing, such that the fault detection network is trained; wherein the corresponding condition information comprises an indication of the normal condition or the fault condition.

11. A fault detection device, **characterized in that**, the fault detection device comprises:

a sampling module (11), configured to sample to obtain a first voltage signal and a first current signal from a circuit path;
a phase adjustment module (12), configured to performing a phase adjustment on the first voltage signal and the first current signal to generate a second voltage signal and a second current signal; and
a processor (13), configured to transmit the second voltage signal and the second current signal to a pre-trained fault detection network to process and generate a fault detection result, and control connection of the circuit path according to the fault detection result.

12. The fault detection device according to claim 11, **characterized in that**, the phase adjustment module (12) comprises a phase locker (PLL22);
the phase locker (PLL22) is configured to determine a fundamental frequency of the first voltage signal, obtain phase information of the first voltage signal at the fundamental frequency, and adjust phases of the first voltage signal and the first current signal according to the phase information.

13. The fault detection device according to claim 12, **characterized in that**, wherein:

the phase locker (PLL22) comprises a first frame buffer unit (221) and a first DFT unit (222);
the first frame buffer unit (221) is connected to the sampling module (11), and is configured to buffer samples of the first voltage signal for at least one DFT cycle;
the first DFT unit (222) is connected to the first frame buffer unit (221), and is configured to perform a discrete Fourier transform on the samples of the first voltage signal output from the first frame buffer unit (221) to obtain the phase information, and to feedback the phase information to the first frame buffer unit (221); and
the first frame buffer unit (221) is further configured to adjust a phase of the first voltage signal according to the phase information.

14. The fault detection device according to claim 12 or 13, **characterized in that**, the fault detection device further comprises a second frame buffer unit (223) and a second DFT unit (224);

the second frame buffer unit (223) is respectively connected to the sampling module (11) and the phase locker (PLL22), and is configured to buffer samples of the first current signal for at least one DFT cycle, and to adjust a phase of the first current signal according to the phase information to obtain a second current signal;
the second DFT unit (224) is configured to perform a discrete Fourier transform on the second current signal.

15. The fault detection device according to claim 14, **characterized in that**, the second frame buffer unit (223) is further configured to calculate a phase difference between a sampling clock of the first voltage signal and a sampling clock of the first current signal, and adjust the phase of the first current signal according to the phase difference.

**16.** The fault detection device according to claim 14 or 15, **characterized in that**, the fault detection device further comprises a frequency normalization module (24);
the frequency normalization module (24) is connected to the first DFT unit (222) and the second DFT unit (224), and is configured to perform a spectrogram scaling on the second voltage signal and the second current signal after the discrete Fourier transform through interpolation filtering or spline interpolation to normalize frequencies of the second voltage signal and the second current signal.

**17.** The fault detection device according to any one of claims 11 to 16, **characterized in that**, the sampling module (11) comprises:

a voltage signal sampling circuit (211), configured to sample from the circuit path to acquire the first voltage signal; and
a current signal sampling circuit (212), configured to sample from the circuit path to acquire the first current signal.

FIG. 1

2

- voltage signal sampling circuit 211
- current signal sampling circuit 212
- 21
- 22
- first frame buffer unit 221
- second frame buffer unit 223
- DFT unit 222
- DFT unit 224
- PLL22
- frequency normalization module 24
- processor 23
- K
- v1
- v2
- i1
- i2
- P0
- v2'
- i2'

FIG. 2

FIG. 3

perform a sampling operation to obtain a
first voltage signal and a first current
signal from a circuit path

S110

perform a phase adjustment on the first
voltage signal and the first current signal
to generate a second voltage signal and a
second current signal

S120

transmit the second voltage signal and
the second current signal to a fault
detection network pre-trained to
accordingly process and generate a fault
detection result

S130

operably disconnect the circuit path when
a fault is detected based on the fault
detection result

S140

FIG. 4

perform sampling operation to respectively obtain multiple raw voltage signals and raw current signals corresponding to a normal condition and a fault condition

S210

perform phase adjustments on the raw voltage signals and raw current signals to respectively generate sample voltage signals and sample current signals

S220

transmit the sample voltage signals, the sample current signals, and corresponding condition information to the fault detection network for processing, such that the fault detection network is trained

S230

FIG. 5

Europäisches Patentamt

European Patent Office

Office européen des brevets

# EUROPEAN SEARCH REPORT

Application Number

EP 22 20 3265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/276827 A1 (SHARMA SANTOSH KUMAR [IN] ET AL) 1 October 2015 (2015-10-01) * abstract * * figures 1, 4 * * paragraphs [0027] - [0040] * * paragraph [0042] - paragraph [0057] * ----- | 1-17 | INV. H02H3/38 |
| X | EP 2 741 389 A1 (ALSTOM TECHNOLOGY LTD [CH]) 11 June 2014 (2014-06-11) * abstract * * figure 4 * * paragraph [0086] - paragraph [0090] * ----- | 1-17 | |
| A | WO 2006/123962 A1 (KOZHELSKY SERGEI VLADIMIROVICH [RU] ET AL.) 23 November 2006 (2006-11-23) * abstract * * figure 1 * ----- | 1-17 | |

| | |
|---|---|
| | TECHNICAL FIELDS SEARCHED (IPC) |
| | H02H |

The present search report has been drawn up for all claims

| Place of search | Date of completion of the search | Examiner |
|---|---|---|
| Munich | 17 March 2023 | Operti, Antonio |

EPO FORM 1503 03.82 (P04C01)

**ANNEX TO THE EUROPEAN SEARCH REPORT
ON EUROPEAN PATENT APPLICATION NO.**

EP 22 20 3265

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2023

| Patent document cited in search report | | Publication date | Patent family member(s) | | Publication date |
|---|---|---|---|---|---|
| US 2015276827 | A1 | 01-10-2015 | CN 106133535 A | | 16-11-2016 |
| | | | EP 3126856 A1 | | 08-02-2017 |
| | | | US 2015276827 A1 | | 01-10-2015 |
| | | | WO 2015153440 A1 | | 08-10-2015 |
| EP 2741389 | A1 | 11-06-2014 | EP 2741389 A1 | | 11-06-2014 |
| | | | RU 2013106761 A | | 20-08-2014 |
| | | | WO 2014090816 A1 | | 19-06-2014 |
| WO 2006123962 | A1 | 23-11-2006 | NONE | | |

EPO FORM P0459

For more details about this annex : see Official Journal of the European Patent Office, No. 12/82